# FASCICULE DE BREVET EUROPEEN

(11) **EP 3 740 668 B1**
(45) Date de publication et mention de la délivrance du brevet: **29.03.2023**
(21) Numéro de dépôt: 18842425.3
(22) Date de dépôt: 11.12.2018
(51) Int. Cl.: F02N 11/08, F02N 11/10, G01R 31/327, G01R 31/00

(54) **PROCEDE DE DETECTION DE DEFAUT, NOTAMMENT DE COLLAGE, D'UN RELAIS PARMI DEUX RELAIS DISPOSES EN SERIE DANS UNE LIGNE DE COMMANDE D'UN DEMARREUR DE VEHICULE AUTOMOBILE**
VERFAHREN ZUR ERFASSUNG EINES DEFEKTS, SO WIE EINER VERSCHWEISSUNG, EINES VON ZWEI IN SERIE GESCHALTETEN RELAIS IN EINER STEUERLINIE EINES ANLASSERS FÜR EIN KRAFTFAHRZEUG
METHOD FOR DETECTING A FAULT, IN PARTICULAR A STICKING, OF ONE OF TWO RELAYS PLACED IN SERIES IN A CONTROL LINE OF A MOTOR VEHICLE STARTER

(30) Priorité: 16.01.2018 FR 1850327
(43) Date de publication de la demande: 25.11.2020
(73) Titulaire: PSA Automobiles SA, 78300 Poissy (FR)
(72) Inventeur: DAUNAS, Olivier, 95280 JOUY LE MOUTIER (FR)
(86) Numéro de dépôt international: PCT/FR2018/053186
(87) Numéro de publication internationale: WO 2019/141910

(56) Documents cités:
- EP-A1- 2 199 594
- EP-B1- 2 199 594
- DE-A1-102006 034 837
- DE-A1-102011 002 157
- DE-A1-102015 208 377
- FR-A1- 2 979 125
- FR-A1- 3 058 795
- JP-A- 2001 327 001
- US-A1- 2014 032 037

## Description

La présente invention concerne un procédé de détection de collage d'un relais d'une paire de relais électriques disposés en série dans une ligne de commande délivrant une tension de commande pour un démarreur, notamment un démarreur à aimant, de moteur à combustion interne équipant un véhicule automobile.

La paire de relais comprend un relais d'autorisation de pilotage, dit « relais d'autorisation », et un relais de commande ou de demande de pilotage, dit « relais de commande ». En fonctionnement, le relais d'autorisation se ferme avant et s'ouvre après le relais de commande. Le démarreur est alimenté quand les deux relais sont fermés suivant une commande de fermeture respective.

La présente invention trouve une application particulièrement intéressante pour la détection de relais commandés pour un démarreur de moteur à combustion interne de véhicule automobile muni d'un système d'arrêt et de redémarrage automatiques du moteur à combustion interne, couramment appelé système STT ou « start and stop », ou tout véhicule nécessitant des arrêts et redémarrages fréquents du moteur à combustion interne du véhicule automobile.

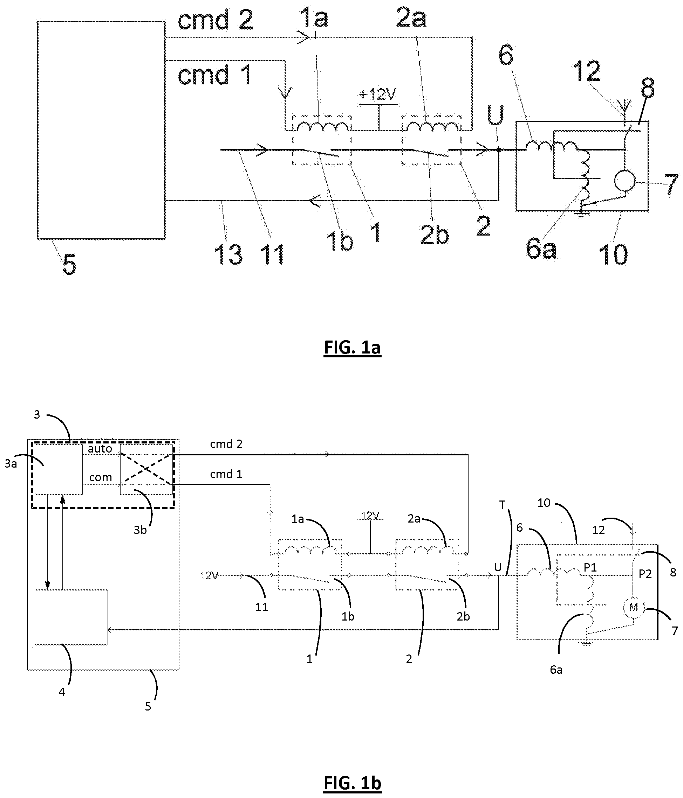

En se référant à la figure 1a, il est connu d'utiliser un démarreur 10 de véhicule automobile comprenant un moteur électrique à aimant 7 alimenté par une ligne d'alimentation de puissance 12 électrique et relié à une ligne d'alimentation secondaire 11. Cette ligne d'alimentation secondaire 11 alimente deux solénoïdes 6, 6a présents dans le démarreur 10. Ces solénoïdes 6, 6a assurent principalement en tant que relais électromagnétiques deux fonctions lorsqu'ils sont alimentés électriquement.

La première fonction est la fermeture d'un contacteur 8 permettant l'alimentation électrique du moteur électrique 7 du démarreur 10 par la ligne d'alimentation électrique 12. La deuxième fonction est l'engrènement des pignons du moteur électrique 7 avec ceux du moteur à combustion interne du véhicule automobile afin d'entraîner le moteur à combustion interne. L'engagement entraîne la mise en rotation du moteur électrique.

Dans un contexte automobile, le dispositif de commande d'alimentation électrique du ou des solénoïdes 6, 6a de démarreur 10 doit à la fois interdire les risques d'activation et de désactivation intempestives de commandes de démarrage, tout en étant résistant en utilisation.

La ligne d'alimentation secondaire 11 traverse deux relais 1, 2, disposés en série, en plus des moyens d'activation 6, 6a du contacteur 8 de la ligne d'alimentation 12 que sont le ou les solénoïdes 6, 6a. Chaque relais 1, 2 comprend respectivement un bobinage 1a, 2a, et un contacteur 1b, 2b disposé sur la ligne 11 d'alimentation secondaire. Lorsque le bobinage 1a (respectivement 1b) n'est pas alimenté électriquement le contacteur 2a (respectivement 2b) est ouvert. L'alimentation électrique du solénoïde 1a, (respectivement 2a), opère la fermeture du contacteur 2a, (respectivement) 2b.

Une unité de contrôle commande 5 supervise l'alimentation électrique des solénoïdes 6 et 6a par commande des deux relais 1, 2, ceci respectivement par les commandes cmd 1, cmd 2, des bobinages 1a, 1b.

L'unité de contrôle commande 5 pilote donc deux sorties de type filaire en tout ou rien. Chaque sortie commande directement l'alimentation électrique d'un des bobinages 1a, 1b, avec une commande cmd 1 et cmd 2 par relais 1, 2. Les fermetures des deux relais 1, 2, alimentent les solénoïdes 6, 6a du démarreur 10 qui mettent en rotation celui-ci par son moteur électrique 7.

Les relais 1, 2, commandent l'engagement d'un pignon de démarreur et pas directement l'alimentation du moteur électrique 7. Cette alimentation est réalisée en fin d'engagement mécanique du pignon par une ligne d'alimentation 12 électrique. Le moteur électrique 7 du démarreur 10 est donc alimenté par cette ligne d'alimentation 12 électrique quand les deux relais 1, 2, sont fermés suivant une commande de fermeture cmd 1, cmd 2 respective.

Comme précédemment indiqué, l'un des deux relais 1, 2, de la ligne de commande 11 est un relais d'autorisation se fermant avant et s'ouvrant après l'autre relais dit relais de commande. Un signal d'autorisation de pilotage et un signal de commande de pilotage, générés par l'unité de contrôle commande 5, sont alternés entre les deux relais 1, de manière à ce que chaque relais 1, 2, joue successivement le rôle de relais d'autorisation et de relais de commande pour des redémarrages successifs. A chaque activation, ce n'est donc jamais le même relais 1, 2, qui subit le pic de courant dû aux solénoïdes 6, 6a.

Les relais 1, 2, ont l'inconvénient de parfois rester collés, avec des lamelles internes suite à une commande de fermeture. Cela vaut surtout pour le relais de commande mais cela peut se produire aussi sur le relais d'autorisation. Ce collage peut être temporaire ou définitif. Les collages définitifs arrivent généralement en fin de vie des relais 1, 2. Un collage temporaire peut se produire à tout moment et le relais collé 1, 2, peut se décoller par exemple à une prochaine activation, la mise sous tension du relais 1, 2, pouvant initier son décollement.

Il convient donc d'effectuer régulièrement des diagnostics pour vérifier si un des relais 1, 2, reste collé et éventuellement estimer si cet état collé est temporaire ou définitif.

Le document EP2199594B1 décrit un dispositif de démarrage d'un moteur à combustion interne pour la fonction d'arrêt et de démarrage d'un véhicule, comportant un premier relais avec une ligne principale raccordée à un commutateur d'allumage; un second relais avec une ligne principale raccordée à la ligne principale dudit premier relais et à un circuit d'allumage d'un démarreur. Les lignes principales, lorsqu'elles sont fermées, déterminent l'activation du démarreur pour le démarrage du moteur à combustion interne.

Une unité de commande électronique comporte des moyens de commande des relais, de sorte que lors de conditions de démarrage du moteur au moyen de la fonction d'arrêt et de redémarrage automatiques, il est déterminé la fermeture des lignes principales des relais avec un premier délai entre ces derniers, de sorte qu'il soit possible d'échanger le délai entre les relais pour des démarrages successifs alternés.

Ce document décrit des moyens de diagnostic qui vérifient la tension entre les lignes principales des relais et des moyens de commande des relais qui déterminent l'ouverture et la fermeture alternées des lignes principales afin de permettre le diagnostic.

Dans ce document, il n'est pas décrit comment le diagnostic s'effectue sur un des relais, comment gérer le démarreur dans le cas d'un relais collé. De plus, le diagnostic ainsi réalisé ne permet pas de différencier entre un état collé temporaire du relais et un état permanent. Le diagnostic des relais est seulement présent pour vérifier si l'un des relais est resté collé.

On connait encore le document DE102015208377A1, correspondant au préambule de la revendication 1.

La présente invention vise à améliorer la situation.

Pour atteindre cet objectif, il est prévu selon l'invention un procédé de détection de collage d'un relais appartenant à une paire de relais électriques disposés en série dans une ligne de commande délivrant une tension de commande pour un démarreur de moteur à combustion interne équipant un véhicule automobile, un moteur électrique du démarreur étant alimenté quand les deux relais sont fermés, chacun par un signal distinct, un des deux signaux étant un signal dit d'autorisation commençant avant et se terminant après l'autre signal, dit signal de commande, dans lequel on effectue une mesure d'une grandeur physique représentative de la tension de commande et on détecte un collage du relais ayant reçu le signal de commande, lorsqu'on détermine, à partir de ladite mesure, que la tension de commande est non nulle entre le début du signal d'autorisation et le début du signal de commande, et tant qu'aucun relais n'est détecté comme étant collé, les signaux d'autorisation et de commande sont alternés entre les deux relais à chaque démarrage de moteur à combustion interne ayant lieu au cours d'une même phase courante de roulage du véhicule.

Ainsi, on effectue une mesure d'une grandeur physique avant la commande du démarreur représentative de la tension de commande pour détecter un éventuel collage du relais.

L'invention permet de réaliser une détection simple et efficace d'un relais déficient qui reste collé. Le relais de commande est testé lors d'un démarrage, quand il n'est pas encore fermé, c'est-à-dire avant le front montant du signal de commande, alors que le relais d'autorisation est déjà fermé sur commande du signal d'autorisation. Aucun courant ne devrait alors passer à travers la ligne de commande sauf si le relais de commande est déficient.

Dans le cadre de l'invention, il est profité que les relais d'autorisation et de commande sont ouverts l'un après l'autre pour faire une détection sur le relais de commande encore en position ouverte tandis que le relais d'autorisation est déjà en position fermée, au début d'un démarrage. Si une tension est détectée en relecture dans la ligne de commande, c'est que le relais de commande, alors en théorie ouvert, est resté collé.

En outre, selon l'invention, la fenêtre de diagnostic pendant laquelle un éventuel collage du relais de commande est recherché, est située avant le pilotage de ce relais de commande. Autrement dit, la détection du collage est faite avant même le pilotage du relais de commande, entre le début du signal d'autorisation et le début du signal de commande. Ainsi, si le relais de commande est collé, le collage est détecté avant que le moteur du démarreur soit démarré (dans le cas d'un collage, une micro activation du démarreur est fait durant la détection). Cela offre l'avantage de ne pas perturber le diagnostic ou la détection par un effet de la force électromotrice du démarreur, en particulier dans le cas d'un démarreur à aimant. L'invention permet de réaliser un diagnostic de relais sur un système équipé d'un démarreur à aimant.

On peut par exemple mesurer une tension électrique en un point de la ligne de commande situé entre le relais le plus proche du démarreur et ledit démarreur afin de mesurer ladite grandeur physique représentative de la tension de commande.

Avantageusement encore, les signaux d'autorisation et de commande sont alternés entre les deux relais au moment où le signal de commande débute. Ainsi, l'alternance du signal d'autorisation et du signal de commande entre les deux relais est provoquée sur le front montant du signal de commande.

Dans un mode de réalisation particulier de l'invention, dès que le relais ayant reçu le signal de commande est détecté comme étant collé, il est immédiatement déclenché une alternance des signaux d'autorisation et de commande entre les deux relais.

Avantageusement, après l'alternance déclenchée immédiatement après que le relais a été détecté comme étant collé, l'alternance des signaux d'autorisation et de commande entre les deux relais est inhibée, le signal d'autorisation étant envoyé au relais détecté comme étant collé jusqu'à la fin de la phase courante de roulage.

Grâce à cela, le relais déficient devient au moins temporairement relais d'autorisation, sans alternance, ce qui permet d'éviter un démarrage intempestive, non souhaité.

Dans un mode de réalisation particulier de l'invention, lors d'une phase suivante de roulage du véhicule automobile commençant après un arrêt de la phase courante de roulage, au premier démarrage, on envoie au relais ayant été détecté comme étant collé le signal de commande et à l'autre relais le signal d'autorisation, on effectue une nouvelle mesure de ladite grandeur physique représentative de la tension de commande et, si on détermine, à partir de la nouvelle mesure, que la tension de commande est non nulle entre le début du signal d'autorisation et le début du signal de commande, le collage du relais ayant été précédemment détecté comme collé est confirmé.

Ladite phase de roulage suivante est celle qui suit la phase de roulage pendant laquelle un relais a été détecté comme étant collé. Cette phase de roulage suivante permet de réaliser un deuxième diagnostic qui peut confirmer ou infirmer le premier diagnostic. Si le collage est confirmé lors du deuxième diagnostic, il est considéré avec une forte probabilité que le relais considéré est définitivement collé. Si le deuxième diagnostic montre que le relais s'est décollé, il est déterminé que le collage détecté n'était que temporaire.

Un ou plusieurs autres diagnostics peuvent être mis en oeuvre lors d'une ou plusieurs phases suivantes de roulage.

Avantageusement, quand le collage du relais est confirmé, il est effectué immédiatement un seule alternance des signaux d'autorisation et de commande envoyés sur les relais et ensuite une inhibition de l'alternance, le relais confirmé comme étant collé restant alors le relais recevant le signal d'autorisation jusqu'à la fin de ladite phase suivante de roulage.

Avantageusement encore, quand le collage du relais est confirmé, un signal de remontée de défaut indiquant un relais collé est envoyé à un calculateur contrôlant une ou plusieurs fonctions requérant des démarrages du moteur du véhicule et, sur réception dudit signal, ladite ou les fonctions sont inhibées. Par exemple, la fonction est une fonction STT d'arrêt et de redémarrage automatique du véhicule.

L'invention concerne aussi un ensemble de démarrage de moteur à combustion interne comprenant:
- un démarreur équipé d'un moteur électrique alimenté par une ligne d'alimentation électrique,
- une ligne de commande de la ligne d'alimentation électrique, la ligne de commande présentant une paire de relais disposés en série et étant destinée à délivrer une tension de commande au démarreur,
- une unité de contrôle commande à laquelle est reliée la ligne de commande,
- des moyens de mesure pour effectuer une mesure d'une grandeur physique représentative de la tension de commande délivrée au démarreur par la ligne de commande ;
caractérisé en ce que l'unité de contrôle commande est agencée pour mettre en oeuvre le procédé qui vient d'être défini.

Avantageusement, ladite unité de commande est agencée pour détecter un collage du relais ayant reçu le signal de commande, lorsqu'on détermine que la tension de commande est non nulle, à partir d'une mesure de ladite grandeur physique représentative de la tension de commande, entre le début du signal d'autorisation et le début du signal de commande.

La présente invention permet d'éviter des commandes non voulues par l'unité de contrôle commande du démarreur pour la mise en place d'une fonction spécifique nécessitant des arrêts et des redémarrages du moteur à combustion interne. De telles commandes non voulues représentent un risque chute de tension du réseau de bord à cause de l'appel de courant, voire des risques de casse du démarreur.

Avantageusement, le démarreur est un démarreur à aimant.

L'invention concerne enfin un véhicule automobile comprenant un moteur à combustion interne, caractérisé en ce qu'il comprend un tel ensemble de démarrage pour le moteur à combustion interne.

Avantageusement, le véhicule automobile est un véhicule micro hybride, un véhicule équipé d'un système d'arrêt et de redémarrage automatiques du moteur à combustion interne et/ou un véhicule équipé d'un système de roue libre automatisé. Ces véhicules ont la particularité de présenter des arrêts et des redémarrages fréquents du moteur à combustion interne.

D'autres caractéristiques, buts et avantages de la présente invention apparaîtront à la lecture de la description détaillée qui va suivre et au regard des dessins annexés donnés à titre d'exemples non limitatifs et sur lesquels :
- la figure 1a est une représentation schématique d'un ensemble de démarrage comprenant un démarreur et un système de commande du démarreur intégrant une unité de contrôle commande et une ligne de commande du démarreur intégrant une paire de relais dits respectivement d'autorisation et de commande, selon l'art antérieur ;
- la figure 1b est une représentation schématique d'un ensemble de démarrage comprenant un démarreur et un système de commande du démarreur intégrant une unité de contrôle commande et une ligne de commande du démarreur intégrant une paire de relais dits respectivement d'autorisation et de commande, pouvant mettre en oeuvre le procédé de détection de l'invention ;

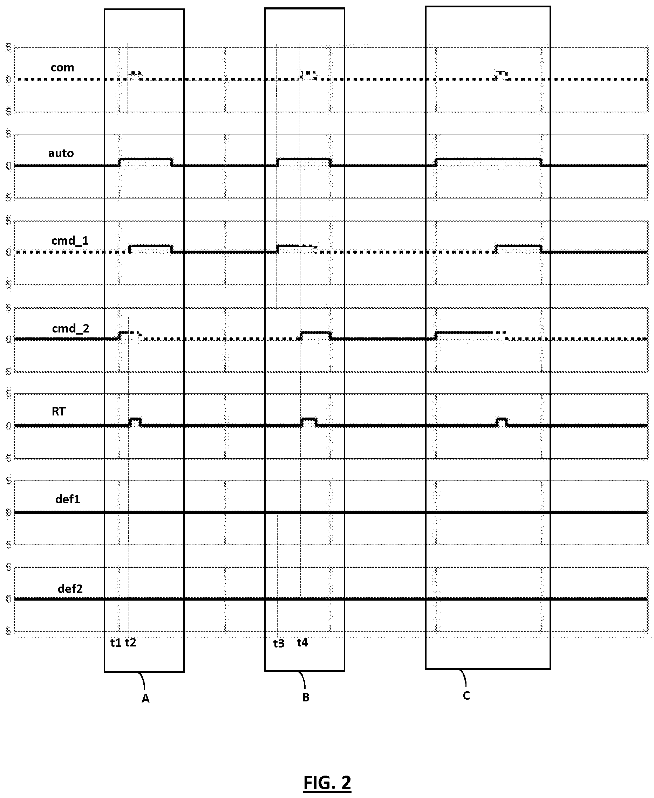

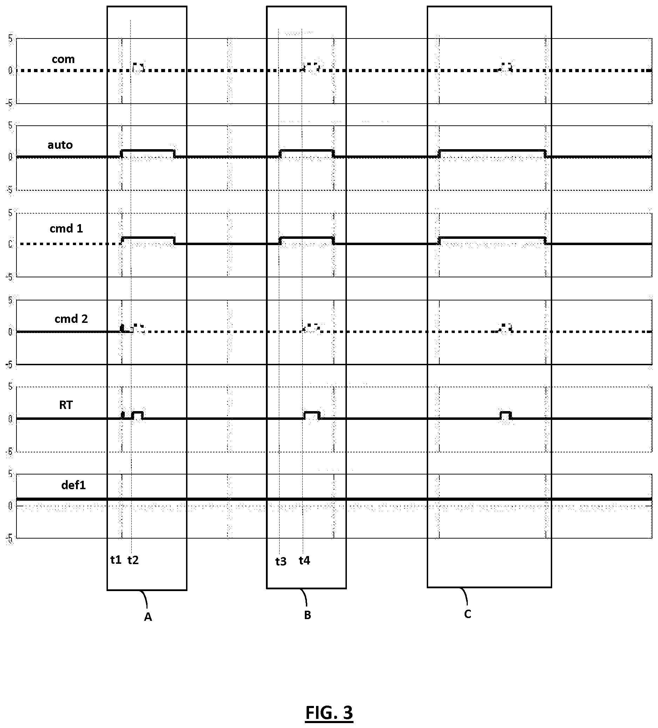

- les figures 2 et 3 illustrent le fonctionnement du procédé de détection de collage d'un relais selon un mode de réalisation particulier de l'invention, respectivement en l'absence de collage et en cas de collage d'un relais.

D'emblée, on notera que sur les différentes figures, les éléments portant les mêmes références sont des éléments identiques ou correspondants.

Sur la figure 1b, on a représenté un ensemble de démarrage pouvant mettre en oeuvre le procédé de l'invention. Il comprend un démarreur 10 et un système de commande du démarreur 10 comportant une unité de contrôle commande, ou calculateur, 5 et une ligne de commande 11 avec une paire de relais 1, 2 de commande du démarreur 10. Une ligne spécifique de commande de chaque bobinage 1a, 2a du relais 1, 2 part de l'unité de contrôle commande 5 pour aboutir au relais associé 1, 2.

Le démarreur 10 est destiné à démarrer un moteur à combustion interne pouvant équiper un véhicule automobile. Il intègre un moteur électrique 7 alimenté par une ligne 12 d'alimentation électrique et est aussi relié à la ligne de commande 11.

La ligne de commande 11, destinée à délivrer une tension de commande T au démarreur 10, est reliée, à l'une de ses extrémités, à une source d'alimentation électrique (en l'espèce une batterie d'alimentation 12V non représentée) et, à son autre extrémité, à la masse. Elle comprend, entre ses deux extrémités :
- les deux relais 1, 2, disposés en série,
- des moyens 6, 6a d'activation d'un organe électrique 8 d'ouverture et de fermeture 8 de la ligne d'alimentation 12.

Les deux relais 1, 2 sont interposés entre l'unité de contrôle commande 5 et le démarreur 10. Les moyens d'activation 6, 6a et l'organe électrique 8 sont ici intégrés dans le démarreur 10.

L'unité de contrôle commande 5 intègre un module de commande 3 qui pilote l'alimentation électrique de la ligne de commande 11 par commande ou pilotage des deux relais 1, 2.

Chaque relais 1 (2) comprend un contacteur 1b (2b) et un bobinage électrique associé 1a (2a). Chaque bobinage 1a, 2a est relié au module de commande 3 par l'intermédiaire d'une ligne spécifique de commande relais cmd 1, cmd 2. Le contacteur 1b (2b) peut être ouvert ou fermé selon l'alimentation électrique du bobinage associé 1a (2a), qui est contrôlée par un signal de commande relais transmis sur la ligne de commande relais correspondante cmd1 (cmd2).

L'organe électrique 8 d'ouverture et de fermeture de la ligne 12 d'alimentation électrique du moteur 7 du démarreur 10 est par exemple un interrupteur ou un contacteur.

Les moyens d'activation de l'organe électrique 8 peuvent comprendre deux solénoïdes 6, 6a, respectivement d'appel et de maintien. Les deux solénoïdes 6 et 6a sont disposés en série dans la ligne de commande 11 entre une entrée du démarreur 10 et la masse. Le solénoïde d'appel est disposé à l'entrée du démarreur 10 et le solénoïde de maintien 6a est relié à la masse. On note P1 un point de raccordement intermédiaire entre les deux solénoïdes 6, 6a. Le moteur électrique 7 est connecté en parallèle au solénoïde de maintien 6a. Plus précisément, il est connecté, d'un côté, au point de raccordement intermédiaire P1 et, de l'autre côté, à la masse. La ligne d'alimentation électrique 12, destinée à alimenter le moteur 7 du démarreur 10, comporte l'organe électrique d'ouverture/fermeture 8 et est aussi reliée au moteur électrique 7, par connexion à un point de raccordement P2 disposé entre le point P1 et le moteur 7.

Comme précédemment explicité, les deux relais 1, 2 sont disposés en série dans la ligne de commande 11 et commandés par les lignes de commande relais spécifiques respectives cmd1, cmd2. En fonctionnement, quand les deux relais 1, 2 sont fermés suivant des commandes de fermeture envoyées sur les lignes cmd 1, cmd 2 respectives, les deux solénoïdes 6, 6a à l'intérieur du démarreur 10 sont alimentés électriquement et ferment le contacteur ou interrupteur 8 dans la ligne d'alimentation 12 du démarreur 10. Il en résulte que le moteur électrique 7 est alimenté électriquement par sa ligne d'alimentation électrique 12.

Sur figure 1b, la référence « com » indique un signal de commande ou de demande de pilotage, dit « signal de commande », et la référence « auto » indique un signal d'autorisation de pilotage, dit « signal d'autorisation ». Chronologiquement, le signal d'autorisation auto commence avant et se termine après le signal de commande com. Le module de commande 3 comprend une unité de pilotage 3a et une unité de bascule ou d'alternance 3b. L'unité de pilotage 3a génère le signal d'autorisation auto et le signal de commande com et pilote l'unité de bascule 3b qui permet soit d'envoyer le signal de commande com vers la ligne de commande cmd1 et le signal d'autorisation auto vers la ligne de commande cmd2, soit à l'inverse d'envoyer le signal de commande com vers la ligne de commande cmd2 et le signal d'autorisation auto vers la ligne de commande cmd1.

L'unité de contrôle commande 5 comprend des moyens d'acquisition, des moyens de traitement par instructions logicielles contenues dans une mémoire ainsi que des moyens de commande, tels que requis pour mettre en oeuvre le procédé de l'invention. A cet effet, l'unité de contrôle commande 5 intègre un module 4 de diagnostic des relais 1, 2 comportant des moyens de mesure d'une grandeur physique représentative de la tension de commande T dans la ligne de commande 11 et des moyens de détection d'un collage de l'un des deux relais 1, 2, à partir d'une mesure réalisée.

Dans l'exemple de réalisation décrit ici, la grandeur physique mesurée est la tension T de la ligne 11 de commande. La mesure de cette tension T est effectuée par exemple en un point U de la ligne 11 de commande compris entre le relais 2, le plus proche du démarreur 10, et le démarreur 10. Ce point U de mesure est relié par une ligne de tension 13 au module 4 de diagnostic des relais 1, 2.

Les figures 2 et 3 illustrent la mise en oeuvre procédé de détection de l'invention, selon un exemple particulier de réalisation purement illustratif. Sur ces figures, on a représenté différents graphes référencés com, auto, cmd_1, cmd_2, RT, défi, def2, où :
- la référence com désigne le signal de commande ;
- la référence auto désigne le signal d'autorisation,;
- la référence cmd_1 désigne le signal reçu par le bobinage 1a du relais 1 sur la ligne de commande cmd 1 ;
- la référence cmd_2 désigne le signal reçu par le bobinage 2a du relais 2 sur la ligne de commande cmd 1 ;
- la référence RT indique le retour de tension par la ligne 13, autrement dit la tension mesurée au point U sur la figure 1b ;
- la référence défi indique un possible défaut pour le relais 1 ;
- la référence def2 indique un possible défaut pour le relais 2.

On rappelle que, chronologiquement, le signal d'autorisation auto commence avant et se termine après le signal de commande com.

Le signal de commande com est représenté en pointillés et le signal d'autorisation auto est représenté en trait plein, y compris sur les graphes cmd_1 et cmd_2.

En référence aux deux figures 2 et 3, le procédé de détection d'un éventuel collage de l'un des deux relais 1, 2 est mis en oeuvre lors d'une phase de roulage comportant plusieurs démarrages successifs du véhicule, celui-ci étant équipé d'un système STT (de l'anglais « start and stop ») d'arrêt et de redémarrage automatique du moteur à combustion interne du véhicule. On entend par l'expression « phase de roulage », une session d'usage du véhicule compris entre une mise sous contact, par exemple par clé de contact ou par un bouton de démarrage, du véhicule et une coupure du contact par les mêmes moyens. A la mise sous contact, classiquement le ou les calculateurs du véhicule sont réveillés, le véhicule est désormais apte à fournir un couple moteur. A la coupure du contact, le ou les calculateurs sont mis en veille, le véhicule n'est plus apte à fournir du couple moteur. On considère un arrêt et un redémarrage effectué par un système STT d'arrêt et de redémarrage automatique, comme faisant partie d'une même phase de roulage.

La figure 2 illustre un premier exemple de mise en oeuvre du procédé de l'invention, pour lequel aucun défaut, autrement dit aucun collage, n'est détecté pour les relais 1 et 2, l'exemple de ce pilotage ayant ici lieu pendant une phase de roulage, dite phase courante de roulage. Sur la figure 2, on a représenté trois démarrages successifs référencés A, B et C, à titre d'exemple illustratif. Le démarrage A peut être le premier démarrage ou un redémarrage ultérieur de la phase de roulage courante.

Tant qu'aucun des relais 1, 2 n'est détecté comme étant collé, les signaux d'autorisation (auto) et de commande (com) sont alternés entre les deux relais 1, 2 à chaque démarrage du moteur à combustion interne ayant lieu au cours de la même phase courante de roulage du véhicule, sur commande de l'unité de contrôle commande 5. En d'autres termes, l'unité de contrôle commande 5 commande une alternance des signaux de commande com et d'autorisation auto entre les deux relais 1 et 2, à chaque redémarrage. Ainsi, le signal d'autorisation auto est envoyé en alternance soit sur la ligne de commande relais cmd 1 du premier relais 1, soit sur la ligne de commande relais cmd 2 du deuxième relais 2. De façon analogue, le signal de commande com est envoyé en alternance soit sur la ligne de commande relais cmd 2 du deuxième relais 2, soit sur la ligne de commande relais cmd 1 du premier relais 1. Les signaux d'autorisation (auto) et de commande (com) sont alternés entre les deux relais 1, 2 au moment où le signal de commande (com) débute. En d'autres termes, l'alternance est déclenchée au début du signal de commande com, sur le front montant du signal de commande com.

Il est effectué une mesure de la tension de commande en sortie U des deux relais 1, 2 via le retour de tension RT par le module de diagnostic 4.

Ainsi, sur cette figure 2, au début du premier démarrage A, le signal d'autorisation auto est envoyé au relais 2, via la ligne de commande cmd 2 tandis que le signal de commande com est envoyé au relais 1, via la ligne de commande cmd 1.

Lorsque l'on mesure la tension T de la ligne de commande 11 entre le relais le plus proche du démarreur, ici le relais 2, et ce démarreur 10, entre le moment où le signal d'autorisation débute (figure 2, instant t1) et le moment où le signal de commande com débute (figure 2, instant t2), une tension nulle est relevée entre ces deux moments. On considère donc le relais 1 ayant reçu le signal de commande com comme non collé.

Au moment où le signal de commande com débute, c'est-à-dire sur le front montant du signal de commande com, l'unité de contrôle commande 5 provoque une alternance de l'envoi des signaux : le signal d'autorisation auto est donc envoyé au relais 1, via la ligne de commande cmd 1, tandis que tandis que le signal de commande com est envoyé au relais 2, via la ligne de commande cmd 2.

Au début du démarrage B suivant (figure 2, instant t3), le signal d'autorisation auto est toujours envoyé au relais 1, via la ligne de commande cmd 1, tandis que tandis que le signal de commande com est envoyé au relais 2, via la ligne de commande cmd 2. Puis, au moment où le signal de commande com débute (figure 2, instant t4), c'est-à-dire sur le front montant du signal de commande com, l'unité de contrôle commande 5 provoque une nouvelle alternance des signaux : le signal d'autorisation auto est envoyé au relais 2, via la ligne de commande cmd 2, tandis que le signal de commande com est envoyé au relais 1, via la ligne de commande cmd 1.

La mesure de la tension T de la ligne de commande 11 entre le moment t3 où le signal d'autorisation auto débute et le moment t4 où le signal de commande com début indique une tension nulle entre ces deux moments. On considère donc le relais 2 ayant reçu le signal de commande com comme non collé.

Au démarrage C suivant, tout se passe comme dans le cas du premier démarrage A.

A chaque démarrage (figure 2, graphe RT), la tension de sortie mesurée au point U est non nulle lorsque les deux relais 1, 2 sont fermés et nulle dès l'ouverture de l'un des relais 1, 2.

Ainsi, tant que le relais ayant été commandé par le signal de commande com n'est pas détecté comme étant collé, les relais 1, 2, reçoivent alternativement le signal d'autorisation auto et le signal de commande com, l'alternance étant déclenchée à chaque fois que le signal de commande com débute (c'est-à-dire sur chaque front montant du signal de commande com).

La figure 3 illustre un exemple de mise en oeuvre du procédé de détection de l'invention, dans un cas de collage du premier relais 1. Sur la figure 3, on a représenté les trois démarrages successifs référencés A, B et C analogues à ceux de la figure 2, à la différence près que l'un des relais, en l'espèce le relais 1, est collé, comme le montre le graphe def1 (ligne au-dessus de la ligne « 0 »).

Au début du premier démarrage A, le signal d'autorisation auto est d'abord envoyé au relais 2, via la ligne de commande cmd 2, tandis que le signal de commande com est envoyé au relais 1, via la ligne de commande cmd 1.

Comme précédemment explicité en référence à la figure 2, la tension T de la ligne de commande 11 est mesurée au point U entre le début du signal d'autorisation auto et le début du signal de commande com. Dès le début du signal d'autorisation (figure 3, instant t1), la mesure montre une tension non nulle sur la ligne de commande 11 (graphe RT, instant t1) alors que le premier relais 1 doit être normalement ouvert (en attente du signal de commande com à venir). Un collage du premier relais 1 est alors détecté par le module de diagnostic 4.

Suite à cette détection de collage, il est immédiatement procédé à une inversion de commande : une alternance des signaux d'autorisation auto et de commande com entre les deux relais 1, 2 est déclenchée afin d'envoyer le signal d'autorisation auto sur le relais 1 défectueux (collé). Autrement dit, via la commande de l'unité de bascule 3b, le premier relais 1 reçoit le signal d'autorisation auto via la commande cmd 1 et le deuxième relais 2 reçoit le signal de commande com via la commande cmd 2, juste après l'instant t1 de début du signal d'autorisation. Cette inversion est réalisée dès le début du signal d'autorisation auto au démarrage A. Ainsi le signal d'autorisation auto est d'abord reçu sur le deuxième relais 2 (non défectueux) à l'instant t1 de début du signal d'autorisation auto puis il est basculé quasi-instantanément sur le premier relais 1 détecté comme étant collé. En pratique, ce basculement est effectué après un très court laps de temps suivant l'instant t1, ce laps de temps correspondant au temps nécessaire pour détecter le collage et déclencher l'alternance. Ce basculement quasi-instantané du signal d'autorisation ici du relais 2 vers le relais 1 au début du premier démarrage A est visible sur la figure 3 par un pic de commande sur le graphe cmd_2 et par un pic de tension sur la tension mesurée RT, sensiblement à l'instant t1 de début du signal d'autorisation auto au premier démarrage A.

Le basculement du signal d'autorisation auto du deuxième relais 2 sur le premier relais 1 détecté comme étant collé permet d'assurer un bon fonctionnement de l'ensemble de démarrage, le signal de commande com étant reçu par le relais 2 a priori non défectueux, malgré la détection du relais 1 comme étant collé. Pour les démarrages suivants B et C, l'alternance des signaux com et auto est inhibée jusqu'à la fin de la phase courante de roulage. A ce stade, le défaut du premier relais 1 n'est pas confirmé.

Ainsi, quand le relais ayant reçu le signal de commande com est détecté comme étant collé, il est effectué une seule alternance de signaux d'autorisation et de commande entre les deux relais 1, 2, puis un blocage de cette alternance, le relais détecté comme étant collé restant alors le relais d'autorisation recevant le signal d'autorisation auto, pendant le reste de la phase courante de roulage.

Prendre un relais collé comme relais recevant le signal d'autorisation auto est moins défavorable que de prendre un relais collé comme relais recevant le signal de commande com. Cette modification d'alternance permet de stopper immédiatement l'alimentation du ou des solénoïdes 6, 6a. L'alternance va rester bloquée dans ce mode jusqu'à la fin de la phase courante de roulage.

Dans un premier mode de réalisation de l'invention, le module de diagnostic 4 ne remonte pas de défaut détecté au véhicule lors de ce premier diagnostic ayant permis de détecter un relais collé. Autrement dit, il n'envoie pas un signal de remontée de défaut indiquant un relais collé au niveau de l'ensemble de démarrage du moteur à combustion interne du véhicule, à un calculateur du véhicule contrôlant une fonction utilisant le démarrage, par exemple la fonction STT d'arrêt et de redémarrage automatique du moteur du véhicule.

Afin de décider s'il convient ou non de remonter le défaut dans le véhicule et éventuellement à un utilisateur, une nouvelle phase de roulage ou « phase suivante de roulage » est réalisée afin de procéder à un nouveau diagnostic. Pendant cette nouvelle phase de roulage, un décollage du relais ayant été détecté comme collé est susceptible de se produire ou pas.

Ainsi, à une phase suivante de roulage commençant après un arrêt de la phase courante de roulage du véhicule automobile au cours de laquelle un relais (ici le relais 1) a été détecté comme collé, il est effectué une nouvelle détection (ou un nouveau diagnostic) pour confirmer ou non l'état collé du relais ayant été détecté collé. L'alternance est forcée pour que le relais ayant été détecté comme étant collé reçoive le signal de commande com, lors du premier démarrage du roulage suivant.

Au début du premier démarrage de cette nouvelle phase de roulage, l'unité de contrôle commande 3 force l'alternance pour que le signal de commande com soit envoyé sur le relais détecté comme collé, ici le relais 1, et que le signal d'autorisation auto soit envoyé sur le deuxième relais 2. Le module de diagnostic 4 effectue une nouvelle mesure de la tension de commande au point U entre le début du signal d'autorisation auto et le début du signal de commande com. Si le module de diagnostic 4 détermine, à partir de cette nouvelle mesure, que la tension de commande est non nulle entre le début du signal d'autorisation auto et le début du signal de commande com, le collage du relais ayant été précédemment détecté comme collé est confirmé.

En cas de confirmation du collage du relais 1, il est alors procédé à une inversion des signaux auto et com entre les deux relais 1, 2. Par une commande appropriée de l'unité de bascule 3b, le premier relais 1 reçoit le signal d'autorisation auto et le deuxième relais 2 reçoit désormais le signal de commande com.

Pour les redémarrages suivants, l'alternance des commandes reste inhibée jusqu'à la fin de cette phase suivante de roulage, ici avec le premier relais 1 restant avec le signal d'autorisation auto.

Ainsi, quand le relais détecté comme collé lors du roulage précédent est confirmé comme étant collé, il est effectué une seule alternance des signaux relais d'autorisation auto et de commande com sur les relais 1, 2. Ensuite, cette alternance est inhibée, le relais confirmé comme étant collé recevant alors le signal d'autorisation auto pendant toute la suite de la phase de roulage.

Comme l'état collé du relais confirmé comme tel peut être vraisemblablement permanent, l'unité de contrôle commande 5 peut envoyer un signal de remontée d'un défaut indiquant un relais collé au niveau de l'ensemble de démarrage du moteur à combustion interne, pendant la phase de roulage. Ce signal de remontée de défaut peut être envoyé à un calculateur gérant une fonction du véhicule requérant des démarrages autres qu'un démarrage initial, par exemple la fonction STT d'arrêt et de démarrage automatique. Sur réception de ce signal de remontée de défaut, ces fonctions peuvent être au moins temporairement suspendues. En outre, une interface homme-machine peut signaler au conducteur le défaut détecté et lui demander d'aller dans un garage pour procéder à un remplacement du relais déficient.

Si la mesure de tension au point U révèle une tension de commande nulle entre le début du signal d'autorisation auto et le début du signal de commande com lors de ce deuxième diagnostic, le collage du relais ayant été précédemment détecté comme collé n'est pas confirmé. Il est alors considéré que ce relais s'est décollé et le procédé se poursuit normalement, avec des alternances de signaux auto et com entre les deux relais à chaque début de signal de commande, comme décrit en référence à la figure 2, tant qu'aucun autre collage n'est détecté.

Le procédé de l'invention est particulièrement adapté dans le cas d'un démarreur à aimant. Toutefois, il peut être utilisé pour tout autre type de démarreur, notamment un démarreur bobiné.

Le véhicule automobile peut être un véhicule hybride, un véhicule équipé d'un système d'arrêt et de redémarrage automatiques du moteur à combustion interne et/ou un véhicule équipé d'un système de roue libre automatisé ou tout autre fonction impliquant des arrêts et redémarrages fréquents du moteur à combustion interne du véhicule automobile. Ces fonctions peuvent être combinées entre elles ou prises unitairement.

Le mode de roulage roue libre automatisé est une fonction qui permet à un véhicule automobile lancé de continuer son roulage tout en découplant une transmission aux roues motrices du véhicule du moteur à combustion interne du véhicule. La transmission comprend classiquement une boîte de vitesses et son embrayage. Le moteur à combustion interne n'effectuant plus d'entraînement peut alors être mis au ralenti ou à l'arrêt. Cette fonction est activée lorsque la vitesse du véhicule est suffisante, par exemple pour un profil extra-urbain et notamment un profil de route descendante.

En variante, l'unité de contrôle commande pourrait envoyer un signal de remontée d'un défaut indiquant qu'un relais collé a été détecté, dès la première détection du collage lors d'une phase de roulage, sans attendre une confirmation du collage lors d'une phase de roulage suivante.

## Revendications

1. Procédé de détection de collage d'un relais d'une paire de relais (1, 2) électriques disposés en série dans une ligne de commande (11) délivrant une tension de commande pour un démarreur (10) de moteur à combustion interne équipant un véhicule automobile, un moteur électrique (7) du démarreur (10) étant alimenté quand les deux relais (1, 2) sont fermés, chacun par un signal distinct, un des deux signaux étant un signal dit d'autorisation (auto) commençant avant et se terminant après l'autre signal, dit signal de commande (com), dans lequel on effectue une mesure d'une grandeur physique représentative de la tension de commande et on détecte un collage du relais ayant reçu le signal de commande (com), lorsqu'on détermine, à partir de la mesure, que la tension de commande est non nulle entre le début du signal d'autorisation (auto) et le début du signal de commande (com), **caractérisé en ce que** tant qu'aucun relais n'est détecté comme étant collé, les signaux d'autorisation (auto) et de commande (com) sont alternés entre les deux relais à chaque démarrage de moteur à combustion interne ayant lieu au cours d'une même phase courante de roulage du véhicule.

2. Procédé selon la revendication précédente, dans lequel les signaux d'autorisation (auto) et de commande (com) sont alternés entre les deux relais au moment où le signal de commande (com) débute.

3. Procédé selon l'une des revendications précédentes, dans lequel, dès que le relais ayant reçu le signal de commande (com) est détecté comme étant collé, il est immédiatement déclenché une alternance des signaux d'autorisation (auto) et de commande (com) entre les deux relais.

4. Procédé selon la revendication précédente, dans lequel, après l'alternance déclenchée immédiatement après que le relais a été détecté comme étant collé, l'alternance des signaux d'autorisation (auto) et de commande (com) entre les deux relais est inhibée, le signal d'autorisation (auto) étant envoyé au relais détecté comme étant collé jusqu'à la fin de la phase courante de roulage.

5. Procédé selon l'une quelconque des revendications précédentes, dans lequel, lors d'une phase suivante de roulage du véhicule automobile commençant après un arrêt de ladite phase courante de roulage, au premier démarrage, on envoie au relais ayant été détecté comme étant collé le signal de commande (com) et à l'autre relais le signal d'autorisation (auto), on effectue une nouvelle mesure de ladite grandeur physique représentative de la tension de commande et, si on détermine, à partir de la nouvelle mesure, que la tension de commande est non nulle entre le début du signal d'autorisation (auto) et le début du signal de commande (com), le collage du relais ayant été précédemment détecté comme collé est confirmé.

6. Procédé selon la revendication précédente, dans lequel, quand le collage du relais est confirmé, il est effectué immédiatement un seule alternance des signaux d'autorisation (auto) et de commande (com) envoyés sur les relais et ensuite une inhibition de l'alternance, le relais confirmé comme étant collé restant alors le relais recevant le signal d'autorisation (auto) jusqu'à la fin de ladite phase suivante de roulage.

7. Procédé selon l'une quelconque des revendications 5 et 6, dans lequel, quand le collage du relais est confirmé, un signal de remontée de défaut indiquant un relais collé est envoyé à un calculateur contrôlant au moins une fonction du véhicule requérant des arrêts et démarrages du moteur à combustion interne du véhicule, telle qu'une fonction d'arrêt et de redémarrage automatique du véhicule, et, sur réception dudit signal de remontée de défaut, la fonction est inhibée.

8. Ensemble de démarrage de moteur à combustion interne comprenant :
- un démarreur (10) équipé d'un moteur électrique (7) alimenté par une ligne d'alimentation (12) électrique,
- une ligne de commande (11) de la ligne d'alimentation, la ligne de commande (11) présentant une paire de relais (1, 2) disposés en série et étant destinée à délivrer une tension de commande pour le démarreur (10),
- une unité de contrôle commande (5) à laquelle est reliée la ligne de commande (11),
- des moyens de mesure (13) pour effectuer une mesure d'une grandeur physique représentative de la tension de commande ;
**caractérisé en ce que** l'unité de contrôle commande (5) est agencée pour mettre en oeuvre le procédé selon l'une quelconque des revendications 1 à 7.

9. Véhicule automobile comprenant un moteur à combustion interne, **caractérisé en ce qu'**il comprend un ensemble de démarrage (10) selon la revendication 8 pour le moteur à combustion interne.

## Patentansprüche

1. Verfahren zum Erkennen eines Hängenbleibens eines Relais eines in Reihe geschalteten elektrischen Relaispaares (1, 2) in einer eine Steuerspannung liefernden Steuerleitung (11) für einen an einem Kraftfahrzeug, einem Elektromotor, angebrachten Verbrennungsmotorstarter (10). (7) des Starters (10) versorgt wird, wenn die beiden Relais (1, 2) jeweils durch ein separates Signal geschlossen werden, wobei eines der beiden Signale ein sogenanntes Berechtigungssignal (auto) ist, das vor dem anderen Signal, dem sogenannten Steuersignal (com), anfängt und endet wobei eine Messung einer physikalischen Größe durchgeführt wird, die die Steuerspannung darstellt, und ein Hängenbleiben des Relais, das das Steuersignal (com) empfangen hat, erfasst wird, wenn aus der Messung bestimmt wird, dass die Steuerspannung ungleich Null ist, zwischen den Beginn des Berechtigungssignals (auto) und Beginn des Steuersignals (com), **dadurch gekennzeichnet, dass** solange kein Relais als hängend erkannt wird, die Berechtigungssignale (auto) und Steuerung (com) zwischen den beiden Relais hin- und hergeschaltet werden jedes Mal, wenn der Verbrennungsmotor während der gleichen Stromphase gestartet wird Fahrzeug fahren.

2. Verfahren nach dem vorhergehenden Anspruch, bei dem das Autorisierungssignal (auto) und das Steuersignal (com) zwischen den beiden Relais in dem Moment gewechselt werden, in dem das Steuersignal (com) beginnt.

3. Verfahren nach einem der vorhergehenden Ansprüche, bei dem, sobald das Relais, das das Steuersignal (com) empfangen hat, als festgefahren erkannt wird, ein Wechsel der Autorisierung (auto) und Steuerung (com ) zwischen den beiden Relais erfolgt.

4. Verfahren nach dem vorhergehenden Anspruch, bei dem nach dem unmittelbar nach Erkennen des Steckenbleibens des Relais ausgelösten Wechsels der Wechsel des Autorisierungssignals (auto) und des Steuersignals (com) zwischen den beiden Relais gesperrt wird, das Autorisierungssignal (auto ) bis zum Ende der aktuellen Fahrphase an das als festgefahren erkannte Relais gesendet.

5. Verfahren nach einem der vorhergehenden Ansprüche, bei dem während einer folgenden Fahrphase des Kraftfahrzeugs, die nach einem Stopp der aktuellen Fahrphase beginnt, beim ersten Start das als festgefahren erkannte Relais an die Steuerung gesendet wird signal (com) und dem anderen Relais das Autorisierungssignal (auto), wird eine neue Messung der physikalischen Größe durchgeführt, die repräsentativ für die Steuerspannung ist, und, falls aus der neuen Messung bestimmt wird, dass die Steuerspannung ungleich Null ist zwischen dem Start des Autorisierungssignals (auto) und dem Start des Steuersignals (com) wird das Hängenbleiben des zuvor als hängend erkannten Relais bestätigt.

6. Verfahren nach dem vorhergehenden Anspruch, bei dem, wenn das Verbinden des Relais bestätigt wird, ein einmaliger Wechsel der an die Relais gesendeten Autorisierungs- (auto) und Kontroll-(com) Signale sofort durchgeführt wird und dann eine Sperrung des Wechsels erfolgt. das als blockiert bestätigte Relais bleibt dann das Relais, das das Autorisierungssignal (auto) empfängt, bis zum Ende der nächsten Rollphase.

7. Verfahren nach einem der Ansprüche 5 und 6, bei dem, wenn das Hängenbleiben des Relais bestätigt wird, ein Fehlerrückmeldungssignal, das ein Hängenbleiben des Relais anzeigt, an einen Computer gesendet wird, der mindestens eine Funktion des Fahrzeugs steuert, die Stopps und Starts erfordert B. eine automatische Stopp- und Neustartfunktion des Fahrzeugs, und bei Empfang des Fehlerrückmeldungssignals wird die Funktion gesperrt

8. Verbrennungsmotor-Starterkit bestehend aus:
- einen Anlasser (10), der mit einem leitungsgespeisten Elektromotor (7) ausgestattet ist Stromversorgung (12),
- eine Steuerleitung (11) der Versorgungsleitung, die Steuerleitung (11) mit einem in Reihe geschalteten Relaispaar (1, 2) zur Abgabe einer Steuerspannung für den Starter (10),
- eine Befehlssteuereinheit (5), an die die Befehlsleitung (11) angeschlossen ist,
- Messmittel (13) zum Durchführen einer Messung einer physikalischen Größe, die repräsentativ für die Steuerspannung ist; **dadurch gekennzeichnet, dass** die Befehlssteuereinheit (5) so angeordnet ist, dass sie das Verfahren nach einem der Ansprüche 1 bis 7 implementiert.

9. Kraftfahrzeug mit einem Verbrennungsmotor, **dadurch gekennzeichnet, dass** es eine Starteranordnung (10) nach Anspruch 8 für den Verbrennungsmotor umfasst

## Claims

1. Method for detecting sticking of a relay of a pair of electrical relays (1, 2) arranged in series in a control line (11) delivering a control voltage for an internal combustion engine starter (10) fitted to a motor vehicle, an electric motor (7) of the starter (10) being supplied when the two relays (1, 2) are closed, each by a separate signal, one of the two signals being a so-called authorization signal (auto) starting before and ending after the other signal, called the control signal (com), in which a measurement is made of a physical quantity representative of the control voltage and a sticking of the relay having received the control signal (com) is detected, when it is determined, from the measurement, that the control voltage is non-zero between the start of the authorization signal (auto) and the start of the control signal (com), **characterized in that** as long as no relay is detected as being stuck, the authorization signals (auto) and control (com) are alternated between the two relays each time the internal combustion engine is started during the same current phase of vehicle driving.

2. Method according to the preceding claim, in which the authorization (auto) and control (com) signals are alternated between the two relays at the moment when the control signal (com) begins.

3. Method according to one of the preceding claims, in which, as soon as the relay having received the control signal (com) is detected as being stuck, an alternation of the authorization (auto) and control (com ) between the two relays.

4. Method according to the preceding claim, in which, after the alternation triggered immediately after the relay has been detected as stuck, the alternation of the authorization (auto) and control (com) signals between the two relays is inhibited, the authorization signal (auto) being sent to the relay detected as being stuck until the end of the current driving phase.

5. Method according to any one of the preceding claims, in which, during a following driving phase of the motor vehicle starting after a stoppage of the said current driving phase, on the first start, the relay having been detected as being stuck is sent the control signal (com) and to the other relay the authorization signal (auto), a new measurement is made of said physical quantity representative of the control voltage and, if it is determined, from the new measurement, that the control voltage is non-zero between the start of the authorization signal (auto) and the start of the control signal (com), the sticking of the relay having been previously detected as stuck is confirmed.

6. Method according to the preceding claim, in which, when the bonding of the relay is confirmed, a single alternation of the authorization (auto) and control (com) signals sent to the relays is immediately carried out and then an inhibition of the alternation , the relay confirmed as being stuck then remaining the relay receiving the authorization signal (auto) until the end of the said next rolling phase.

7. Method according to any one of Claims 5 and 6, in which, when the sticking of the relay is confirmed, a fault feedback signal indicating a stuck relay is sent to a computer controlling at least one function of the vehicle requiring stops and starts. of the internal combustion engine of the vehicle, such as an automatic stopping and restarting function of the vehicle, and, on receipt of said fault feedback signal, the function is inhibited.

8. Internal combustion engine starter kit including:
- a starter (10) equipped with an electric motor (7) powered by a line power supply (12),
- a control line (11) of the supply line, the control line (11)
having a pair of relays (1, 2) arranged in series and being intended to deliver a control voltage for the starter (10),
- a command control unit (5) to which the command line (11) is connected,
- measuring means (13) for performing a measurement of a physical quantity representative of the control voltage; **characterized in that** the command-control unit (5) is arranged to implement the method according to any one of claims 1 to 7.

9. Motor vehicle comprising an internal combustion engine, **characterized in that** it comprises a starter assembly (10) according to claim 8 for the internal combustion engine
